# FASCICULE DE BREVET EUROPEEN

(11) **EP 0 557 220 B1**
(45) Date de publication et mention de la délivrance du brevet: **18.09.1996**
(21) Numéro de dépôt: 93420074.2
(22) Date de dépôt: 16.02.1993
(51) Int. Cl.: H01L 21/78, G01P 15/08, G01P 15/125, G01L 9/00

(54) **Micro-capteur capacitif à protection latérale et procédé de fabrication**
Kapazitiver Mikrosensor mit seitlichem Schutz und Verfahren zu dessen Herstellung
Capacitive micro-sensor with lateral protection and method of manufacturing the same

(30) Priorité: 20.02.1992 FR 9202192
(43) Date de publication de la demande: 25.08.1993
(73) Titulaire: SEXTANT AVIONIQUE S.A., F-92366 Meudon la Forêt Cédex (FR)
(72) Inventeur: Thomas, Isabelle, F-26000 Valence (FR); Lefort, Pierre-Olivier, F-26000 Valence (FR); Legoux, Christophe, F-26000 Valence (FR)
(74) Mandataire: de Beaumont, Michel

(56) Documents cités:
- EP-A- 0 369 352
- FR-A- 2 626 073
- PATENT ABSTRACTS OF JAPAN vol. 9, no. 47 (E-299)(1770) 27 Février 1985 & JP-A-59 186 345 (MATSUSHITA DENKI SANGYO K.K. )

## Description

La présente invention concerne le domaine des micro-capteurs capacitifs en silicium. De tels micro-capteurs peuvent par exemple constituer des capteurs de pression, des capteurs d'accélération...

Ces dernières années, se sont développés de nouveaux types de micro-capteurs en silicium, tirant partie des techniques de gravure du silicium développées dans le cadre de la fabrication des composants électroniques à semiconducteurs. Au début, de tels micro-capteurs étaient constitués de l'assemblage de plaquettes de silicium convenablement gravées et de lames minces de verre servant de boîtier étanche ou de plaques de séparation isolantes entre des plaquettes de silicium, ces lames de verre portant éventuellement divers motifs d'électrodes métalliques.

On tend actuellement à développer des micro-capteurs entièrement en silicium, sans plaque de verre jouant un rôle actif. De tels capteurs sont par exemple décrits dans EP-A-0 369 352 et FR-A-2 626 073. Des exemples très schématiques de tels capteurs sont illustrés en figures 1 et 2.

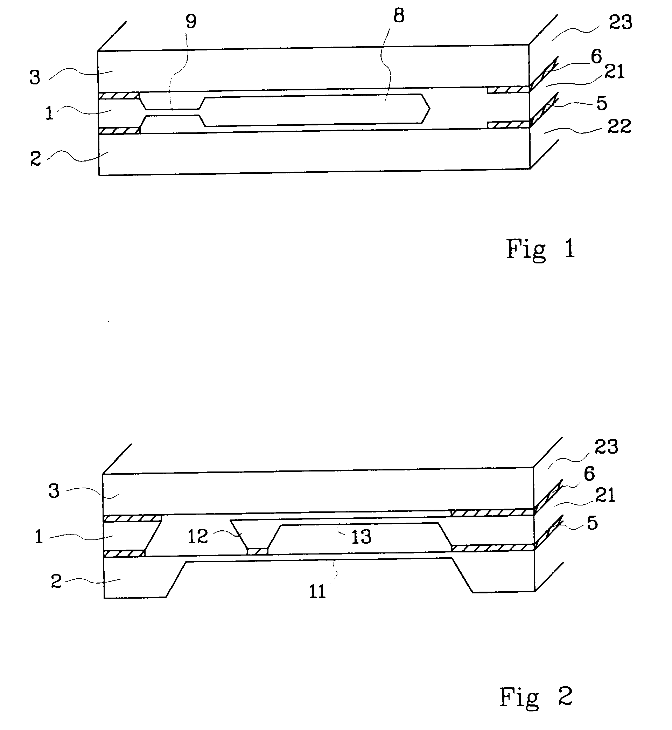

Le capteur de la figure 1 est un capteur d'accélération et le capteur de la figure 2 un capteur de pression. Chacun de ces capteurs comprend une plaquette de silicium centrale 1 prise en sandwich entre des plaquettes de silicium externes 2 et 3. L'isolement entre les plaquettes est assuré par une première bande isolante, généralement une couche d'oxyde de silicium, 5 entre les plaquettes 1 et 2 et une deuxième bande isolante 6 entre les plaquettes 1 et 3. Ces bandes isolantes prennent la forme d'un cadre disposé entre des plaquettes adjacentes, le long des bords de celles-ci. Des couches d'oxyde peuvent être obtenues par croissance ou dépôt à partir de l'une des plaquettes adjacentes. Une fois les trois plaquettes appliquées les unes contre les autres, une soudure est réalisée par un recuit à une température de 900 à 1100°C. Pour cela, la pratique montre qu'il convient que les surfaces de silicium et d'oxyde de silicium en regard aient de très faibles rugosités, par exemple inférieures à 0,5 nm. Les plaquettes de silicium extrêmes 2 et 3 définissent entre elles et avec la partie de cadre de la plaquette de silicium 1 une région dans laquelle est contenue une atmosphère contrôlée, par exemple une atmosphère à très faible pression, appelée vide.

La description précédente s'applique communément aux micro-capteurs des figures 1 et 2.

Dans le cas de la figure 1, qui représente schématiquement une vue en coupe d'un accéléromètre, la plaquette de silicium centrale 1 est gravée avant assemblage pour comprendre un cadre et une plaque centrale ou masselotte 8 fixée au cadre par des barres minces de suspension 9. Une seule barre apparaît dans la vue en coupe schématique de la figure 1. De façon classique, on utilisera des systèmes de suspension à deux ou quatre barres. Les plaquettes externes 1 et 3 délimitent avec le cadre formé à la périphérie de la plaquette centrale un espace vide. On détecte les variations de capacité entre la face supérieure de la masselotte et la plaquette de silicium 3 et éventuellement également entre la face inférieure de la masselotte et la plaquette inférieure 2. Quand le dispositif est soumis à une accélération, la masselotte 8 se déplace par rapport à l'ensemble du dispositif et les capacités susmentionnées varient. Il est également généralement prévu un asservissement électrostatique pour maintenir en place la masselotte par application d'un champ électrique continu et c'est alors le signal d'erreur qui donne une indication de la variation de capacité.

La figure 2 représente très schématiquement une structure constituant un capteur de pression. La plaquette inférieure 2 est gravée pour y former une membrane mince 11. La plaquette 1 est gravée pour former un plot 12 appuyé sur cette membrane. Une lamelle de silicium 13 s'étend entre ce plot et le cadre de la plaquette 1. A nouveau, l'espace délimité par la plaquette supérieure, la plaquette inférieure et le cadre de la plaquette centrale définit un espace vide. Des variations de pression externe déforment la membrane 11 et entraînent une déformation de la tension de la lamelle 13. Cette variation de tension entraîne une variation de la fréquence de résonance du résonateur capacitif constitué par la lamelle 13 et la surface en regard de la plaquette 3. De préférence, la face interne de la plaquette 3 est gravée pour former une bande en saillie en face de la lamelle 13.

Dans le cas de la figure 1, des électrodes 21, 22 et 23 doivent être respectivement solidaires des plaquettes 1, 2 et 3. Dans le cas de la figure 2, seules les électrodes 21 et 23 seront nécessaires.

Ces structures de l'art antérieur, qu'elles utilisent directement une mesure de capacité ou une mesure de fréquence de résonance présentent l'inconvénient que ces mesures sont fortement affectées par la présence de capacités parasites élevées. Ces capacités parasites correspondent essentiellement aux capacités entre le cadre formé dans la plaquette 1 et les parties en regard de la plaquette supérieure et/ou inférieure, capacités dont le diélectrique est constitué par les couches d'isolant (oxyde de silicium) 5 et 6.

Non seulement ces capacités parasites ont une valeur élevée mais en plus cette valeur est variable. Cette variation pouvant notamment résulter d'un dépôt de matière polluante ou d'humidité sur les faces latérales du dispositif dans les zones d'affleurement des couches isolantes 5 et 6. En outre, en pratique, la fabrication d'un micro-capteur tel que celui de la figure 1 ou 2 résulte d'un procédé collectif, chaque plaquette faisant initialement partie d'une tranche de silicium de plus grande dimension, la séparation en capteurs individuels se faisant après les opérations finales d'assemblage et éventuellement de formation de contact. Généralement, cette séparation est effectuée par sciage et, lors du sciage, des particules de silicium peuvent être entraînées vers les zones d'affleurement susmentionnées ce qui augmente la valeur des capacités parasites et peut même au pire court-circuiter deux plaquettes de silicium.

Un objet de la présente invention est de prévoir une structure de micro-capteur permettant d'éviter l'apparition de tels court-circuits totaux ou partiels susceptibles d'affecter les capacités associées aux faces latérales des micro-capteurs.

Un autre objet de la présente invention est de prévoir une structure de micro-capteur permettant d'éviter l'apparition de variation de capacités parasites en fonction de l'environnement dans lequel est placé le micro-capteur.

Pour atteindre ces objets, la présente invention prévoit un micro-capteur capacitif tel que défini dans la revendication 1 et un procédé pour sa fabrication selon la revendication 5.

Selon un mode de réalisation de la présente invention, le micro-capteur capacitif comprend un sandwich de trois plaquettes de silicium.

Selon un mode de réalisation de la présente invention, les encoches sont remplies d'un produit de protection.

Selon un mode de réalisation de la présente invention, les faces latérales du dispositif sont entièrement revêtues d'un produit de protection.

Selon un mode de réalisation du procédé selon la présente invention, on prévoit les étapes consistant à former d'abord une découpe partielle de l'ensemble des trois tranches, jusqu'à découper les deux premières tranches en laissant en place au moins une partie de l'épaisseur de la troisième tranche, à remplir le sillon ainsi formé d'un produit de protection, puis à effectuer une nouvelle découpe pour séparer complètement l'assemblage en dispositifs individuels. La deuxième découpe est effectuée avec une scie moins large que celle ayant servi à la première découpe.

Ces objets, caractéristiques et avantages ainsi que d'autres de la présente invention seront exposés en détail dans la description suivante de modes de réalisation particuliers faite en relation avec les figures jointes parmi lesquelles :
les figures 1 et 2 décrites précédemment sont des vues en coupe schématique d'un micro-capteur d'accélération et d'un micro-capteur de pression selon l'art antérieur ;
la figure 3 est une vue en coupe d'une partie de la zone de séparation entre deux micro-capteurs avant découpe ; et
la figure 4A est une vue en coupe d'une partie de la zone de séparation entre deux micro-capteurs lors d'une phase intermédiaire de découpe ; et
la figure 4B est une vue en coupe d'un bord d'un micro-capteur après une découpe selon la présente invention.

Dans les diverses figures, les épaisseurs relatives des diverses couches et les dimensions latérales des divers éléments ne sont pas à l'échelle mais ont été tracées arbitrairement pour faciliter la lisibilité des figures et en simplifier le dessin.

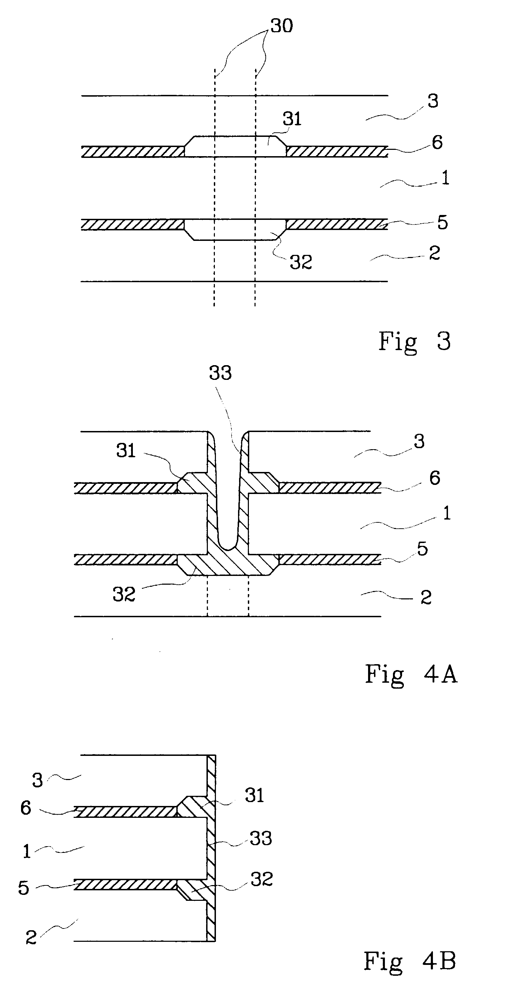

La figure 3 est une vue en coupe représentant une partie d'un assemblage de trois plaques ou tranches de silicium 1, 2 et 3 dans une zone où devra être effectuée une découpe de séparation entre deux dispositifs élémentaires. La région de découpe est marquée par deux traits en pointillés 30 dont l'écart symbolise la largeur d'un trait de scie (par exemple 0,2 à 0,3 mm). Pour fixer des ordres de grandeur, on rappelera que chacune des tranches de silicium 1, 2, 3 a classiquement une épaisseur de l'ordre de 0,3 à 0,4 mm et les couches d'oxyde isolantes 5 et 6 entre les plaquettes une épaisseur de l'ordre du micromètre.

La présente invention prévoit de former dans les plaques, avant assemblage de celles-ci, des rainures 31 et 32 dans les zones où doivent passer les traits de scie. Chacune de ces rainures est plus large que la largeur de découpe, par exemple de l'ordre de 0,4 à 0,5 mm et a une profondeur supérieure à l'épaisseur de la couche d'oxyde, par exemple de l'ordre de 10 à 50 micromètres. Ainsi, la scie, dans son passage, ne vient plus toucher le bord apparent des couches d'oxyde 5 et 6 et il n'y a donc plus de risque d'y "coller" des particules de silicium.

Dans l'exemple représenté, la rainure 31 est formée dans la tranche de silicium 3 et la rainure 32 dans la tranche de silicium 2. On notera que l'une et(ou l'autre de ces rainures pourraient aussi bien être formées dans la tranche centrale 1.

Dans l'exemple de réalisation de la figure 3, les rainures 31 et 32 sont continues. En fait, il suffira qu'il existe des rainures mêmes partielles s'étendant de part et d'autre de la région où est effectuée le trait de scie pour que, après sciage, il demeure dans les faces latérales des encoches dans lesquelles débouchent les couches d'isolement 5 et 6.

La structure illustrée en figure 3 permet d'éviter les dépôts de particules de silicium sur les bords des couches d'oxyde mais n'évite pas les phénomènes de variation de capacité liés par exemple à des dépôts d'humidité sur les parois latérales des dispositifs.

Pour résoudre également ce problème, la présente invention prévoit d'effectuer un sciage partiel, tel qu'illustré en figure 4A, en traversant par exemple les tranches de silicium 3 et 1 jusqu'à arriver à hauteur de la rainure 32. Une fois cette première découpe effectuée, le sillon formé est rempli d'un produit de protection minéral ou organique 33 qui vient protéger les bords apparents des couches d'oxyde 5 et 6. Un deuxième sciage complet est ensuite effectué à travers l'ensemble du dispositif, en redécoupant le produit de protection 33.

De préférence, la première découpe est effectuée avec une scie relativement large, par exemple d'une largeur de lame de 0,3 mm et la deuxième découpe avec une scie de largeur plus faible, par exemple 0,2 mm, de sorte qu'il reste en place sur les faces latérales de chacun des dispositifs une certaine épaisseur de produit de protection en plus du produit de protection ayant pénétré dans les encoches ménagées au niveau des interfaces latérales entre les plaquettes. On obtient alors une structure telle que celle représentée en figure 4B qui permet de résoudre les problèmes exposés en objet.

Bien que la présente invention ait été décrite en relation avec une structure particulière de micro-capteur comprenant un sandwich de trois tranches de silicium séparées latéralement par une couche d'oxyde, la présente invention s'applique à d'autres types de micro-capteur dans lesquels la couche isolante serait autre qu'une couche d'oxyde, par exemple un sandwich d'une couche isolante, d'une couche conductrice et d'une couche isolante. Elle s'applique également au cas où le sandwich ne comprendrait que deux tranches ou plus de trois tranches.

## Revendications

1. Micro-capteur capacitif comprenant un sandwich d'au moins deux plaquettes de silicium (1, 2, 3), une bande périphérique de chaque face principale d'une plaquette en regard d'une plaquette adjacente étant accolée à une bande correspondante de cette plaquette adjacente par l'intermédiaire d'une bande isolante (5, 6), caractérisé en ce que les faces latérales dudit sandwich sont encochées au niveau de l'affleurement de chacune desdites bandes isolantes, chaque encoche (31, 32) ayant une profondeur supérieure à l'épaisseur de la bande isolante (5, 6).

2. Micro-capteur capacitif selon la revendication 1, caractérisé en ce que lesdites encoches sont remplies d'un produit de protection (33).

3. Micro-capteur capacitif selon la revendication 2, caractérisé en ce que les faces latérales du dispositif sont entièrement revêtues d'un produit de protection (33).

4. Micro-Capteur capacitif selon l'une quelconque des revendications 1 à 3, caractérisé en ce qu'il comprend trois plaquettes de silicium.

5. Procédé de fabrication d'un micro-capteur capacitif selon la revendication 1, consistant à assembler au moins deux tranches de silicium séparées par des bandes isolantes, à découper ledit assemblage de tranches de façon à former au moins un sandwich d'au moins deux plaquettes séparées, au moins au niveau de leur pourtour, par une desdites bandes isolantes, des micro-capteurs individuels étant formés par ladite découpe de l'assemblage de tranches, caractérisé en ce que, avant ledit assemblage, une rainure est formée sur l'une au moins des faces en regard de chacune des tranches dans la zone de découpe, ladite rainure étant plus large qu'une largeur de découpe et plus profonde que l'épaisseur des bandes isolantes.

6. Procédé de fabrication selon la revendication 5, dans lequel le micro-capteur capacitif comprend trois plaquettes de silicium, caractérisé en ce qu'il consiste à former d'abord une découpe partielle de l'ensemble des trois tranches, jusqu'à découper les deux premières tranches en laissant en place au moins une partie de l'épaisseur de la troisième tranche, à remplir le sillon ainsi formé d'un produit de protection (33), puis à effectuer une nouvelle découpe pour séparer complètement l'assemblage en dispositifs individuels.

7. Procédé selon la revendication 6, caractérisé en ce que la deuxième découpe est effectuée avec une scie moins large que celle ayant servi à la première découpe.

8. Procédé selon la revendication 7, caractérisé en ce que ladite rainure comprend deux portions de rainures de part et d'autre de la zone de découpe.

## Patentansprüche

1. Kapazitiver Mikrosensor, der eine Sandwich-Anordnung von zumindest zwei Silicium-Platten (1, 2, 3) aufweist, einen Umfangsstreifen jeder Hauptseite der einen Platte gegenüber einer benachbarten Platte, der an einem entsprechenden Streifen dieser benachbarten Platte angebracht ist, und zwar durch einen Isolierstreifen (5, 6), dadurch gekennezichnet, daß die Seitenflächen der Sandwich-Anordnung auf der Anordnungshöhe jeder der Isolierstreifen bzw. vor dem Umfang jedes der Isolierstreifen mit Nuten versehen sind, wobei jede Nut (31, 32) eine Tiefe besitzt, die größer ist als die Dicke des Isolierstreifens (5, 6).

2. Kapazitiver Mikrosensor nach Anspruch 1, dadurch gekennezichnet, daß die Nuten mit einem Schutzmaterial (33) angefüllt sind.

3. Kapazitiver Mikrosensor nach Anspruch 2, dadurch gekennzeichnet, daß die Seitenflächen der Vorrichtung vollständig mit einem Schutzmaterial (33) beschichtet sind.

4. Kapazitiver Mikrosensor nach einem der Ansprüche 1 bis 3, dadurch gekennzeichnet, daß er drei Silicium-Platten aufweist.

5. Herstellverfahren für einen kapazitiven Mikrosensor nach Anspruch 1, das folgende Schritten aufweist: Anordnung von zumindest zwei getrennten Silicium-Scheiben, die durch Isolierstreifen getrennt sin, Ausschneiden der Scheibenanordnung, und zwar so, daß zumindest eine Sandwich-Anordnung von zumindest zwei getrennten Platten gebildet wird, wobei zumindest an ihrem Umfang durch einen der Isolierstreifen, die individuellen bzw. einzelnen Mikrosensoren durch den Schnitt der Scheibenanordnung geformt sind, dadurch gekennzeichnet, daß vor dem Anordnen eine Nut in zumindest einer der gegenüberliegenden Seiten bzw. Oberflächen jeder Scheibe in der Schnittzone gebildet ist, wobei die Nut breiter ist als eine Schnittbreite und tiefer ist, als die Dicke der Isolierstreifen.

6. Herstellverfahren nach Anspruch 5, in dem der kapazitive Mikrosensor drei Silicium-Platten aufweist, dadurch gekennzeichnet, daß es folgende Schritten aufweist: zuerst Bilden eines Teilschnittes der Gesamtheit der drei Scheiben bis zum Schneiden der ersten beiden Scheiben, wobei man zumindest einen Teil der Dicke der dritten Platte an der Stelle läßt, Auffüllen der so geformten Nut mit einem Schutzmaterial (33), dann Ausführen eines neuen Schnittes, um vollständig die Anordnung in einzelne Vorrichtungen zu schneiden.

7. Verfahren nach Anspruch 6, dadurch gekennzeichnet, daß der zweite Schnitt mit einer weniger breiten Säge ausgeführt wird, als die, die zum ersten Schnitt gedient hat.

8. Verfahren nach Anspruch 7, dadurch gekennzeichnet, daß die Nut zwei Nutenteile auf beiden Seiten der Schnittzone aufweist.

## Claims

1. A capacitive micro-sensor including a sandwich of at least two silicon plates (1, 2, 3), a peripheral stripe of each main surface of one plate facing an adjacent plate being assembled to a corresponding stripe of this adjacent plate through an insulating stripe (5, 6), characterized in that the lateral surfaces of said sandwich are provided with notches in front of the periphery of each said insulating stripes, each notch (31, 32) being deeper than the thickness of the insulating stripe (5, 6).

2. The capacitive micro-sensor of claim 1, characterized in that said notches are filled with a protection material (33).

3. The capacitive micro-sensor of claim 2, characterized in that said lateral surfaces of the device are entirely coated with a protection material (33).

4. The capacitive micro-sensor of any of claims 1 to 3, characterized in that it comprises three silicon plates.

5. A method for manufacturing the capacitive micro-sensor of claim 1, comprising the steps of assembling at least two silicon wafers separated by insulating stripes, cutting said wafer assembly to form at least one sandwich of at least two plates separated, at least at their periphery, by one of said insulating stripes, individual micro-sensors being formed by said cutting of said wafer assembly, characterized in that, before said assembling, a groove is formed in at least one of the opposed surfaces of each wafer in the cutting region, said groove being wider than the width of the cutting region and deeper than the thickness of the insulating stripes.

6. The manufacturing method of claim 5, wherein the micro-sensor includes three silicon plates, characterized in that it comprises the step of partially cutting said three wafers assembly, until cutting the first two plates while leaving in place at least a portion of the thickness of the third plate, filling the groove thus formed with a protection product (33), and carrying out a new cutting operation in order to entirely divide the assembly into individual devices.

7. The method of claim 6, characterized in that the second cutting operation is carried out with a narrower saw than the saw that served for the first cutting operation.

8. The method of claim 7, characterized in that said groove includes two groove portions on both sides of the cutting region.
